# EUROPÄISCHE PATENTSCHRIFT

(11) **EP 1 115 199 B1**
(45) Veröffentlichungstag und Bekanntmachung des Hinweises auf die Patenterteilung: **30.07.2008**
(21) Anmeldenummer: 00127828.2
(22) Anmeldetag: 19.12.2000
(51) Int. Cl.: H03G 1/04, H03G 3/30

(54) **Temperaturkompensierte Diodengleichrichterschaltung für einen HF-Pegelregler**
Temperature compensated diode rectifier for RF-level control
Redresseur à diode compensé en température pour commande de niveau d'un signal radiofréquence

(30) Priorität: 30.12.1999 DE 19964024
(43) Veröffentlichungstag der Anmeldung: 11.07.2001
(73) Patentinhaber: Nokia Corporation, 02150 Espoo (FI)
(72) Erfinder: Weiss, Manfred, 88430 Rot-Haslach (DE); Fritzmann, Martin, 89231 Neu-Ulm (DE)
(74) Vertreter: Becker Kurig Straus

(56) Entgegenhaltungen:
- EP-A- 0 560 548
- EP-A- 0 834 987
- US-A- 5 675 245
- US-A- 5 732 332
- PATENT ABSTRACTS OF JAPAN Bd. 1995, Nr. 09, 31. Oktober 1995 (1995-10-31) & JP 7 162239 A (NIPPONDENSO CO LTD), 23. Juni 1995 (1995-06-23)

## Beschreibung

Die Erfindung betrifft eine temperaturkompensierte Diodengleichrichterschaltung gemäß Oberbegriff des Anspruch 1 für einen HF-Pegelregler, die sich zur Steuerung des Ausgangspegels eines HF-Senders in der Verstärkungsregelschleife eines HF-Verstärkers befindet. Eine derartige Diodengleichrichterschaltung ist bsp. aus der US 5 675 245 A bekannt. Der geregelte HF-Verstärker ist vorzugsweise am Ausgang des Modulators eines Funktelefons angeordnet. Dieses ist insbesondere ein Zellulartelefon, das für den Betrieb in verschiedenen Übertragungsbändern ausgelegt ist. Die Regelschaltung hat die Aufgabe, die Sendeleistung für die Antenne des Funktelefons auf einen eingestellten Wert innerhalb eines großen Leistungsbereichs und über einen großen Betriebstemperaturbereich konstant zu halten.

Funktelefone wie Zellulartelefone stellen während des Telefonbetriebes ihre HF-Sendeleistung in Abhängigkeit von der Dichte der Basisstationen in einem Funknetz und den momentanen Übertragungsbedingungen ein. Nach dem Zugang des Funktelefons zum Funknetz weist dieses dem Telefon einen Übertragungskanal zu und überwacht ständig die Übertragungsgüte. Dabei muss neben anderen HF-Parametern, wie Kanalfrequenz und Lage der Zeitschlitze, auch die Höhe der HF-Sendeleistung relativ genau eingehalten werden. In ländlichen Regionen mit einer geringen Anzahl von gleichzeitigen Telefonverbindungen besteht trotz fortgeschrittenem Ausbau der Funknetze im allgemeinen eine geringe Dichte von Basisstationen, so dass bei einem Funkweg von bis zu 40km zur nächsten Basisstation und schlechten Ausbreitungsbedingungen die maximal verfügbare Sendeleistung von etwa 33 dBm (= 2 Watt) benötigt wird. Im Gegensatz dazu, führt bei dichter Besiedelung eine hohe Dichte an Basisstationen zu kurzen Funkwegen, welche oft nur wenige 100 Meter lang sind. Bei solchen kurzen Funkwegen kann zum Reduzieren der Akkubelastung und Gewährleistung der Übertragungsgüte die Sendeleistungen häufig bis auf wenige dBm/mW reduziert werden.
Außerdem können bei hoher Sendeleistung und geringer Zellengröße Gleichkanalstörungen mit anderen Zellen auftreten, wenn gemäß den geltenden Konventionen beide Zellen den gleichen Kanal belegen. Andererseits führt eine zu geringe Sendeleistung zu unzureichender Übertragungsgüte.
Daraus ist ersichtlich, dass die Regelschaltung einerseits die HF-Sendeleistung eines Zellulartelefons abhängig von den Übertragungsbedingungen in einem großen Dynamikbereich möglichst genau und reproduzierbar einstellen soll und dass sie andererseits den eingestellten Wert über einen großen Betriebstemperaturbereich konstant halten muss. Diese Anforderungen sind bei kleinen HF-Sendeleistungen schwer zu realisieren.
Nach dem gegenwärtigen Stand der Entwicklung muss die Sendeleistung inklusive der Leistungsverluste im Zellulartelefon, beispielsweise am Sende/Empfangsschalter, für das Frequenzband um 900MHz in einem Pegelbereich zwischen 5 dBm und 39 dBm und für die Frequenzbänder um 1800 MHz und 1900 MHz in einem Bereich zwischen 0 dBm und 36 dBm einstellbar sein. Für diese Einstellungen wird im Betriebstemperaturbereich von -20° C bis +60° C eine Genauigkeit von ± 0,5 dBm gewünscht.

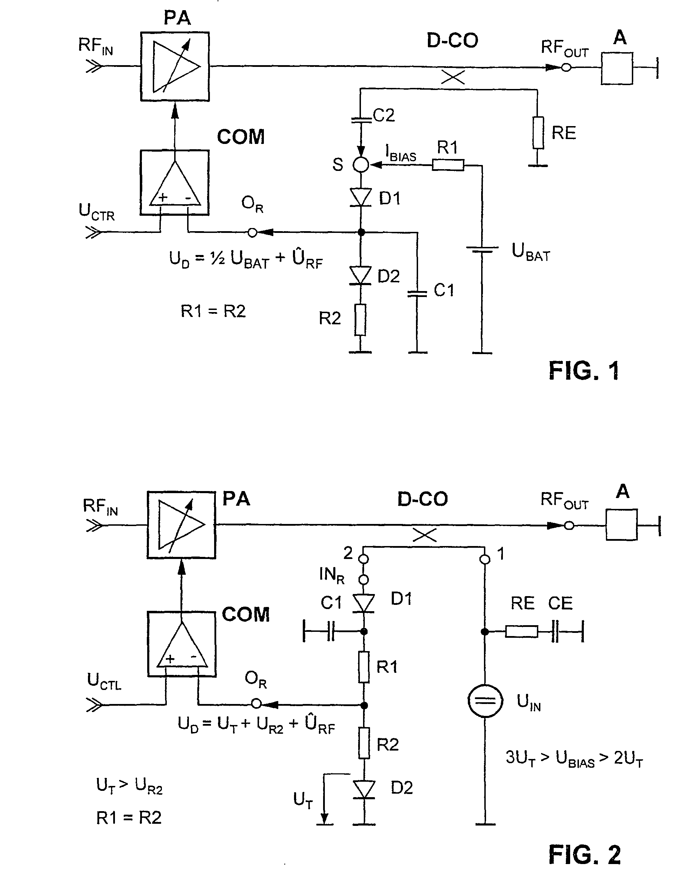

Eine weitere temperaturkompensierte Diodengleichrichterschaltung ist aus der Druckschrift EP 0 834 987 A2 bekannt. Zum besseren Verständnis des Problems werden Unterschiede zwischen der bekannten Lösung und der vorliegenden Erfindung an Hand von FIG.1 erläutert.
Zwischen dem Modulatorausgang eines nicht gezeigten Telefonmoduls und einer Antennenschaltung A liegt ein HF-Verstärker PA zum Verstärken eines Sendesignals RF_{IN}, das im vorliegenden Fall digital auf einem Träger um 900MHz moduliert ist. Um für die Antennenschaltung A ein HF-Ausgangssignal RF_{OUT} im obengenannten Pegelbereich mit definiertem Leistungspegel zu realisieren, stellt eine Regelschleife mit einem Komparator COM, die einen bekannten Soll-lstwert-Vergleich durchführt, die Verstärkung des HF-Verstärkers PA ein. Der Komparator COM vergleicht eine Steuergleichspannung U_{CTR}, die dem gewünschten Leistungspegel entspricht, mit einer Richtspannung U_{D}, deren Höhe vom Leistungspegel des HF-Ausgangssignals RF_{OUT} abhängt. Eine Gleichrichterschaltung mit einer Gleichrichterdiode D1, einem Ladekondensator C1 und einem Lastwiderstand R2 gewinnt die Richtspannung U_{D} aus dem Ausgangssignal RF_{OUT} des Antennenkreises. Die Gleichrichterschaltung ist über einen Richtkoppler D-CO am Antennenkreis angekoppelt.
Im genannten Pegelbereich variiert die Spannung des HF-Ausgangssignals RF_{OUT} um mehr als das Verhältnis n = 1 : 30. Dieses erfordert eine lineare Durchlasskennlinie der Gleichrichterdiode und einen steilen Übergang vom Sperrzustand in den Leitzustand, um auch bei kleinen Pegeln eine geringe Regelabweichung zu erhalten. Dieses wird dadurch erschwert, dass im Extremfall für ein Zellulartelefon nur eine minimale Betriebsspannung von 3 V zur Verfügung steht. Da der Komparator COM nur solche Spannungen mit einander vergleichen kann, die unterhalb seiner eigenen Betriebsspannung liegen, müssen der Richtkoppler D-CO und die Gleichrichterschaltung so ausgelegt sein, dass auch bei maximalem Leistungspegel die Richtspannung U_{D} zumindest noch gering unterhalb dieses Wertes liegt. Das hat zur Folge, dass selbst bei einer idealen Diodenkennlinie der Anteil des gleichgerichteten Ausgangssignals Û_{RF} in der Richtspannung U_{D} beim kleinsten Leistungspegel unter 100 mV liegen würde.
Bei Gleichrichterdioden liegt der Übergang vom Sperrzustand in den Leitzustand außerhalb des Achsennullpunktes. Ohne besondere Maßnahme gelangt nur eine Richtspannung U_{D} zum Ausgang, wenn die Amplitude des ausgekoppelten Ausgangssignals oberhalb einer Schwellspannung U_{T} liegt. Die Diode D1 wird deshalb mit einer Biasspannung oder wie bei der Lösung gemäß der Druckschrift EP 0 834 987 A2 mit einem Biasstrom betrieben. Die Schwellspannung U_{T} ist von der Betriebstemperatur abhängig und liegt beispielsweise bei Schottkydioden im gewünschten Temperaturbereich unter U_{T} = 300mV.
Der Leistungspegel am Ausgang des HF-Verstärkers PA soll von Änderungen der Betriebstemperatur unabhängig sein. Dieses ist bei herkömmlichen Gleichrichterschaltungen jedoch nicht möglich. Bei kleinen Durchlassströmen weisen herkömmliche Dioden eine Temperaturabhängigkeit von etwa 2,0mV/°C auf. Eine zulässige Temperaturänderung von 80° C bedingt somit eine Änderung der Richtspannung U_{D} um 160 mV. Diese ist größer als der Anteil des gleichgerichteten Ausgangssignals Û_{RF} in der Richtspannung.
Zum Kompensieren des Temperaturganges der Richtspannung U_{R} ist aus der Druckschrift EP 0 834 987 A2 bekannt, in Serie mit dem Lastwiderstand R2 eine Kompensationsdiode D2 zu legen und die Gleichrichterdiode D1 eingangsseitig über einen Vorwiderstand R1 mit der Batteriespannung U_{BAT} zu verbinden. Damit entsteht für die Batteriespannung U_{BAT} ein Spannungsteiler mit einer Serienschaltung aus einer Diode D1 oder D2 und einem Widerstand R1 oder R2 in jedem Teilerzweig und am Gleichrichterausgang O_{R} liegt die Richtspannung U_{D} = U_{DO} + Û_{RF}, welche eine Biaskomponente U_{DO} = U_{T} + U_{R2} enthält. Die Batteriespannung U_{BAT} setzt mit einem Biasstrom I_{BIAS} zwischen 20 µA und 200µA beide Dioden D1, D2 in den leitenden Zustand. Der Biasstrom I_{BIAS} ist infolge der Temperaturabhängigkeit der Dioden D1 und D2 ebenfalls temperaturabhängig. Da jedoch bei gleichen Diodentypen und thermisch gekoppelten Dioden D1, D2 die Temperaturabhängigkeit in jedem Teilerzweig gleich ist, bleibt das Teilungsverhältnis des Spannungsteilers stabil, sofern Vorwiderstand R1 und LastwiderstandR2 gleich groß sind und der Komparator COM einen hohen Eingangswiderstand aufweist. In diesem Fall beträgt die Biaskomponente U_{DO} =½U_{BAT} und hängt nur noch von der Höhe der Batteriespannung U_{BAT} ab. Die Richtspannung UM kann somit nur zwischen dem vollen und dem halben Betriebsspannungswert variieren. Dieses verringert praktisch den Variationsbereich des gleichgerichteten Ausgangssignals Û_{RF} in der Richtspannung U_{D}. auf 1,5 Volt. Sind die Widerstände R1 und R2 jedoch verschieden, um beispielsweise den Variationsbereich der Richtspannung U_{D} auszudehnen, so weist die Gleichrichterschaltung einen definierten Temperaturgang auf. Mit dem Verhältnis der Widerstände zueinander kann ein positiver oder negativer Temperaturgang eingestellt werden.
Das ausgekoppelte Ausgangssignal gelangt vom Richtkoppler D-CO über einen Koppelkondensator C2 zu einem Summationspunkt S der Gleichrichterschaltung und wird dort dem Biasstrom I_{BIAS} überlagert. Der Widerstand RE dient zur Anpassung des Richtkopplers D-CO und Abschluss mit dem Wellenwiderstand.
Die Biaskomponente U_{DO} steht immer in einem festen Verhältnis zur Batteriespannung U_{BAT}, welche bei einem Funktelefon stark schwanken kann. Deshalb muss die Höhe der Steuergleichspannung U_{CTR} ebenfalls an die sich ändernde Batteriespannung U_{BATT} gekoppelt werden.

Neben den genannten Nachteilen hat die Praxis ausserdem gezeigt, dass die bekannte Gleichrichterschaltung bei kleinen Leistungspegeln bis etwa 10dBm nur ein gleichgerichtetes Ausgangssignals Û_{RF} von wenige Millivolt am Gleichrichterausgang liefert, so dass die Regelschaltung im unteren Pegelbereich des HF-Ausgangssignals RF_{OUT} unzureichend arbeitet.
Ursache für diesen Mangel ist offenbar das Zusammenführen des Biasstroms I_{BIAS} mit dem ausgekoppelten Anteil des HF-Ausgangssignals RF_{OUT} im Summationspunkt S. Die Dioden D1 und D2 besitzen im Vergleich zu den Widerständen R1 und R2 eine geringe Impedanz. Das bedeutet, die Widerstände R1 und R2 wirken in Bezug auf die Dioden als Stromquelle und stellen oberhalb des Übergangs vom Sperrzustand in den Leitzustand einen relativ stabilen Biasstrom I_{BIAS} ein, so dass die Amplitude des ausgekoppelten HF-Ausgangssignals RF_{OUT} einen Mindestwert an Leistung überschreiten muss, um diesen Strom zu kompensieren und mit der Diode D1 eine vom HF-Ausgangssignal RF_{OUT} abhängige Richtspannung zu erzielen. Bis zur Kompensation des Biasstrom I_{BIAS} weisen die Dioden D1, D2 eine geringe Impedanz auf und die Kapazitäten C1 und C2 bilden einen Wechselspannungsteiler, der das ausgekoppelte HF-Ausgangssignal RF_{OUT} entsprechend teilt. D.h. bei geringem Pegel tritt anstelle des gleichgerichteten Ausgangssignals Û_{RF} in der Richtspannung U_{D} nur eine Wechselspannungskomponente auf. Der Biasstrom in der bekannten Schaltung realisiert also vorrangig die oben beschriebene Temperaturkompensation jedoch unzureichend das Vorspannen der Dioden D1, D2 mit der Schwellspannung U_{T}.

Ausgehend von den genannten Mängeln der bekannten Lösung ist es Aufgabe der vorliegenden Erfindung, eine Gleichrichterschaltung für eine Regelschaltung zum Einstellen des HF-Pegels eines HF-Ausgangssignals an einem Antennenkreis zu schaffen, die auch bei kleinem HF-Ausgangspegel eine ausreichende Empfindlichkeit aufweist. Darüber hinaus soll die Gleichrichterschaltung auch in Geräten arbeiten, die für einen Betrieb in verschiedenen Frequenzbändern ausgelegt sind, in sogenannten "Dual band mobile phones".

Die Lösung der Aufgabe ist eine Gleichrichterschaltung nach Anspruch 1.

Zum Lösen der Aufgabe geht die Erfindung von einer Gleichrichterschaltung aus, welche einen Gleichrichtereingang für das aus dem Antennenkreis ausgekoppelte HF-Ausgangssignal und einen Gleichrichterausgang für eine Richtspannung aufweist. Zum Messen des HF-Pegels des HF-Ausgangssignals ist die Gleichrichterschaltung mit dem Gleichrichtereingang über einen Richtkoppler am Antennenkreis angekoppelt. Die Gleichrichterschaltung weist eine Gleichrichterdiode, einen Ladekondensator und einen Lastwiderstand auf, der vom Gleichrichterausgang zu einem Masseanschluss der Schaltung führt. Der Gleichrichtereingang ist zum Stabilisieren der Richtspannung gegen Temperatureinflüsse mit einer Eingangsgleichspannung verbunden. Ferner liegen in Serie zum Lastwiderstand eine Kompensationsdiode und in Serie zur Gleichrichterdiode ein Vorwiderstand. Damit führt von der Eingangsgleichspannung zum Gleichrichterausgang ein Spannungsteiler, der in jedem Teilerzweig einen Widerstand und eine in Flussrichtung gepolte Diode enthält, so dass die Richtspannung unabhängig von der Temperatur ist und vorzugsweise eine Biaskomponente in Höhe der halben Eingangsgleichspannung enthält.

Im Gegensatz zur bekannten Lösung sind die Schaltungskomponenten der Gleichrichterschaltung und der Richtkoppler jedoch gemäß der Erfindung so mit der Eingangsgleichspannung verbunden, dass die Spannungsamplitude des ausgekoppelten HF-Ausgangssignals zur Eingangsgleichspannung addiert wird und dass der Vorwiderstand der Gleichrichterdiode zwischen dem Ladekondensator und dem Gleichrichterausgang liegt.
Als weitere Maßnahme zum Realisieren der Aufgabe ist gemäß der Erfindung die Eingangsgleichspannung stabilisiert und nur wenig größer als das Doppelte der Schwellspannung einer Diode.

Die Addition des HF-Ausgangssignals wird dadurch erreicht, dass die Anschlüsse des Richtkopplers auf der einen Seite direkt mit der Eingangsgleichspannung und auf der anderen Seite direkt mit dem Gleichrichtereingang verbunden sind, so dass die induktiv ausgekoppelte HF-Wechselspannung in Serie zur Eingangsgleichspannung liegt.

Dieses hat den Vorteil, dass einerseits am Gleichrichtereingang die ausgekoppelte HF-Wechselspannung der Eingangsgleichspannung direkt überlagert ist und bei negativer Amplitude des HF-Ausgangssignals der Eingangsgleichspannung entgegen wirkt, ohne dass ein Signalstrom fließt. Andererseits ist, der gleichgerichtete Anteil des Ausgangssignals in der Richtspannung am Ladekondensator gegenüber dem Gleichrichterausgang nahezu verdoppelt so groß.
Mit den genannten Maßnahmen kann bei kleinem HF-Ausgangspegel die Strom-Spannungsabhängigkeit der Gleichrichterdiode am Übergang vom Sperrzustand in den Leitzustand besser zum Gleichrichten genutzt werden. Die geringe Eingangsgleichspannung ermöglicht nahezu ein Verdoppeln des Variationsbereiches der Richtspannung und damit auch ein entsprechendes Vergrößern der HF- Wechselspannung am Gleichrichtereingang, ohne das die maximale Richtspannung am Gleichrichterausgang einen unzulässig hohen Wert überschreitet.
Die Lage des Vorwiderstandes ermöglicht ausserdem ein weiteres Verdoppeln der HF-Wechselspannung am Gleichrichtereingang, ohne dass die Richtspannung den unzulässig hohen Wert überschreitet oder dass sich der Temperaturgang ändert. Da ausserdem in die Gleichrichterdiode kein fester Biasstrom eingespeist wird, ist bei negativen Signalamplituden keine Ausgangsleistung notwendig, um diesen zu kompensieren.

Im Ergebnis dessen liefert die Diodengleichrichterschaltung gemäß der Erfindung gegenüber der bekannten Lösung bei gleich guter Temperaturkompensation in einem HF-Ausgangspegelbereich, der nach unten um etwa 10dBm erweitert ist, eine ausreichende Empfindlichkeit. Mit dieser Diodengleichrichterschaltung kann eine Regelschaltung des HF-Senders auch Ausgangspegel im Bereich von 0dBm bis 10dBm mit ausreichender Genauigkeit einstellen.

Die Erfindung soll nachstehend an einem Ausführungsbeispiel erläutert werden. Die entsprechenden Figuren zeigen im Einzelnen:
- FIG. 1: eine Regelschaltung für eine HF-Pegelregelung mit einer bekannten temperaturkompensierte Diodengleichrichterschaltung
- FIG. 2: eine Regelschaltung für eine HF-Pegelregelung mit einer temperaturkompensierten Diodengleichrichterschaltung gemäß der Erfindung
- FIG. 3: eine weitere Ausführungsform der Erfindung für die Anwendung in einem Gerät, das in mehreren Frequenzbändern arbeitet.

Die in FIG. 1 gezeigte Regelschaltung enthält die temperaturkompensierte Diodengleichrichterschaltung aus dem Dokument EP 0 834 987 A2, welche der Lösung gemäß der Erfindung am nächsten kommt, und wurde in der Einleitung dieses Dokumentes beschrieben.

FIG. 2 zeigt die bekannte Regelschaltung mit einer Diodengleichrichterschaltung gemäß der Erfindung zum Herleiten einer Richtspannung U_{D} aus einem HF-Ausgangssignal RF_{OUT} für eine Antennenschaltung A. Diese ist ebenfalls mit einem Gleichrichtereingang IN_{R} über einen Richtkoppler D-CO an einen Antennenkreis angekoppelt. Ein HF-Verstärker PA, dessen Verstärkung über einen Komparator COM einstellbar ist, speist die Antennenschaltung A mit einem HF-Ausgangssignal RF_{OUT}, das einen einstellbaren aber konstanten HF-Pegel aufweisen soll. Die Antennenschaltung A enthält im wesentlichen eine Sende/Empfangsantenne und den entsprechenden Antennenumschalter zum wechselseitigen Betrieb der Antenne an einem Sender- und einem Empfängermodul. Die Gleichrichterschaltung weist eine Gleichrichterdiode D1, einen Ladekondensator C1 und einen Lastwiderstand R2 auf und stellt an einem Gleichrichterausgang O_{R} die Richtspannung U_{D} bereit. Zum Stabilisieren der Richtspannung gegen Temperatureinflüsse innerhalb eines für den Gebrauch zugelassenen Temperaturbereichs ist der Gleichrichtereingang IN_{R} über den Richtkoppler D-CO mit einer Eingangsgleichspannung U_{IN} verbunden. Im Gegensatz zur bekannten Lösung ist die Spannung jedoch stabilisiert und nur wenig größer als die doppelte Schwellspannung U_{T} einer Diode D1, D2. Außerdem liegt zur Temperaturkompensation in Serie zum Lastwiderstand R2 eine Kompensationsdiode D2 und in Serie zur Gleichrichterdiode D1 ein Vorwiderstand R1. Der Vorwiderstand R1 ist jedoch einerseits an der Gleichrichterdiode D1 und dem Ladekondensator C1 und andererseits am Gleichrichterausgang O_{R} angeschlossen. Dadurch wird die Richtspannung des Ladekondensators C1 um einen Teilungsfaktor k geteilt, der infolge der Schwellspannung U_{T} der Diode D2 etwas größer als 0,5 ist. Damit kann der Richtkoppler D-CO so dimensioniert werden, dass am Gleichrichtereingang IN_{R} die Amplitude des ausgekoppeltes HF-Ausgangssignal RF_{OUT} entsprechend größer ist als bei der bekannten Lösung. Dadurch gelangt die Gleichrichterdiode D1 bei kleineren HF-Pegeln bereits zum Übergang vom Sperrzustand in den Leitzustand, ohne dass bei maximalen HF-Pegel die maximal zulässige Richtspannung U_{DMAX} = U_{BAT} für den Komparator COM überschritten wird. Wenn der Vorwiderstand R1 und der Lastwiderstand R2 gleich groß sind, bleibt der Teilungsfaktor des Spannungsteilers D1, D2, R1, R2 ebenso wie bei der bekannten Lösung von der Betriebstemperatur unabhängig. Da die Eingangsgleichspannung U_{IN} stabilisiert ist, bleibt die Richtspannung U_{D} frei von Änderungen, die vom Verbrauchszustand der Gerätebatterie abhängen,

Der Richtkoppler weist einen sekundären Anschluss 1 auf, der direkt an der Eingangsgleichspannung angeschlossen ist, und einen sekundären Anschluss 2, der mit dem Gleichrichtereingang IN_{R} verbunden ist, so dass die induktiv ausgekoppelte HF-Wechselspannung und die Eingangsgleichspannung U_{IN} in Serie liegen.

Die Gleichrichterschaltung ist besonders empfindlich, wenn die Eingangsgleichspannung U_{IN} um einige Hundertstel Volt über dem Doppelten der Schwellspannung U_{T} liegt, welche die Dioden D1, D2 bei der im zugelassenen Temperaturbereich tiefsten Betriebstemperatur aufweisen. Bei dieser Betriebstemperatur ist die Schwellspannung U_{T} der Dioden D1, D2 am größten und der Biasstrom I_{BMIN} durch den Spannungsteiler D1, D2, R1, R2 am geringsten. Der Vorwiderstand R1 und der Lastwiderstand R2 müssen in Bezug zur Eingangsgleichspannung U_{IN} und zum Eingangsgleichstrom des Komparators COM einerseits so bemessen sein, dass der Biasstrom I_{BMIN}, der in den Spannungsteiler D1, D2, R1, R2 hineinfließt, noch größer ist als der Eingangsgleichstrom des Komparators COM und dass andererseits der vom Biasstrom I_{BMIN} bewirkte Spannungsabfall am Vorwiderstand R1 wesentlich kleiner ist, als die Schwellspannung U_{T} der Dioden D1, D2. Auf diese Weise ist auch bei der tiefsten Betriebstemperatur im zugelassenen Temperaturbereich und sehr geringem Biasstrom I_{BMIN} in den Gleichrichtereingang IN_{R} hinein die Biaskomponente in der Richtspannung U_{D} annähernd noch halb so groß wie die Eingangsgleichspannung U_{IN}. Bei höheren Betriebstemperaturen sinkt die Schwellspannung U_{T} der Dioden D1, D2 der Biasstrom durch den Spannungsteiler D1, D2, R1, R2 steigt und verursacht an den Widerständen entsprechend höhere Spannungsabfälle.

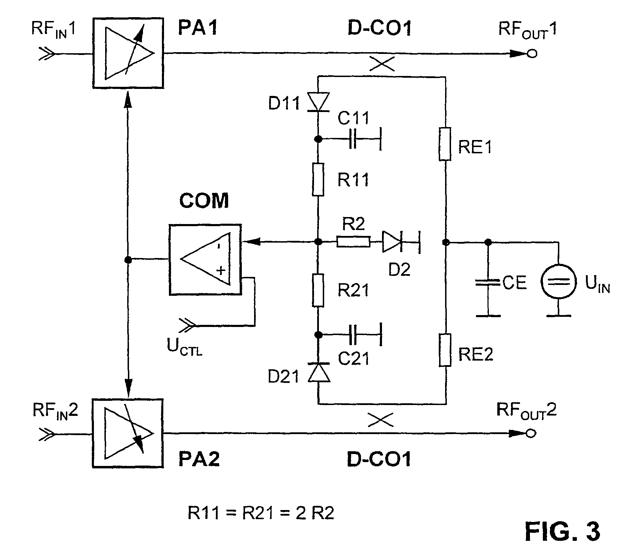

FIG. 3 zeigt eine besondere Ausführungsform der Erfindung für die Anwendung in einem Gerät, das in verschiedenen Frequenzbändern arbeitet, beispielsweise für ein Sendesignal RF_{IN}1 in einem Frequenzband um 900 MHz und ein Sendesignal RF_{IN}2 in einem Frequenzband für um 1800 MHz. Die Schaltung weist für jedes Frequenzband einen regelbaren Leistungsverstärker PA1 und PA2 auf, welche über nicht dargestellte Schalter an entsprechende Modulatorausgänge eines Telefonmoduls geschaltet werden. Außerdem ist für jedes Frequenzband ein eigener Diodengleichrichter mit einer Gleichrichterdiode D11 bzw. D12, einem Ladekondensator C11 bzw. C21 und einem Lastwiderstand R11 bzw. R21 vorhanden. Der Komparator COM und der Lastwiderstand R2 mit Kompensationsdiode D2 werden jedoch gemeinsam genutzt. Das Übertragungsverhältnis der Richtkoppler D-C01 und D-CO2 ist jeweils so ausgelegt, dass für jedes Frequenzband der Variationsbereich des gleichgerichteten Ausgangssignals Û_{RF} in der Richtspannung U_{D} voll ausgenutzt wird. Da über jede Gleichrichterdiode D11, D21 ein Biasstrom I_{BIAS} zum Lastwiderstand R2 und zur Kompensationsdiode D2 fließt, gilt zum Erzielen einer optimalen Temperaturkompensation für die Größe des Lastwiderstandes R2 = ½R11 = ½R21. Infolge des doppelten Biasstroms I_{BIAS} durch die Kompensationsdiode D2 erhöht sich der Spannungsabfall an der Diode um einige Hundertstel Volt aber das Temperaturverhalten bleibt im Vergleich zu den Gleichrichterdiode D11, D21 unverändert. Die Richtkoppler D-CO1 und D-CO2 sind für das HF-Signal mit je einem Abschlusswiderstand RE1, RE2 abgeschlossen. Dadurch wird für jeden Koppler die optimale Richtwirkung erreicht. Mit Hilfe der Kapazität CE werden die Fußpunkte der Abschlusswiderstände auf das Gleichspannungspotential der stabilisierten Gleichspannung gehalten.

## Patentansprüche

1. Temperaturkompensierte Diodengleichrichterschaltung, welche
- zum Herleiten einer Richtspannung (U_{D}) aus einem HF-Ausgangssignal (RF_{OUT}) mit einem Gleichrichtereingang (I_{R}) über einen Richtkoppler (D-CO) mit sekundären Anschlüsse (1,2) ausgangsseitig an einen HF-Verstärker (PA) angekoppelt ist,
- einen Gleichrichterausgang (OR) für die Richtspannung (U_{D}), eine Gleichrichterdiode (D1), einen Ladekondensator (C1) und einen Lastwiderstand (R2) aufweist,
- zum Stabilisieren der Richtspannung gegen Temperatureinflüsse innerhalb eines für den Gebrauch zugelassenen Temperaturbereichs über den Gleichrichtereingang (I_{R}) mit einer stabilisierten Eingangsgleichspannung (U_{IN}) verbunden ist, sowie in Serie zum Lastwiderstand (R2) eine Kompensationsdiode (D2) und in Serie zur Gleichrichterdiode (D1) einen Vorwiderstand (R1) enthält,
**dadurch gekennzeichnet,**
- **dass** die Anschlüsse des Richtkopplers (D-CO) auf der einen Seite mit der Eingangsgleichspannung und auf der anderen Seite mit dem Gleichrichtereingang verbunden sind, wobei die Gleichrichterdiode (D1), Kompensationsdiode (D2), Vorwiderstand (R1), Lastwiderstand (R2) und Richtkoppler (D-CO) so mit der Eingangsgleichspannung (U_{IN}) verbunden sind, dass sich die Spannungsamplitude des ausgekoppelten HF-Ausgangssignals (RF_{OUT}) zur Eingangsgleichspannung (U_{IN}) addiert,
- **dass** der Vorwiderstand (R1) der Gleichrichterdiode (D1) zwischen dem Ladekondensator (C1) und dem Gleichrichterausgang (OR) liegt und
- **dass** die Eingangsgleichspannung (U_{IN}) nur wenig großer ist als das Doppelte der Schwellspannung (U_{T}) einer Diode (D1, D2).

2. Diodengleichrichterschaltung nach Anspruch 1, **dadurch gekennzeichnet, dass** ein sekundärer Anschluss (1) des Richtkopplers (D-CO) direkt mit der Eingangsgleichspannung (U_{IN}) und der andere Anschluss (2) direkt mit dem Gleichrichtereingang (IN_{R}) verbunden ist, so dass die vom Richtkopplers (D-CO) induktiv ausgekoppelte HF- Wechselspannung in Serie zur Eingangsgleichspannung (U_{IN}) liegt.

3. Diodengleichrichterschaltung nach Anspruch 1, **dadurch gekennzeichnet, dass** die Eingangsgleichspannung (U_{IN}) um einige Hundertstel Volt über dem Doppelten der Schwellspannung (U_{T}) liegt, welche die Dioden (D1, D2) bei der im zugelassenen Temperaturbereich minimalen Betriebstemperatur aufweisen.

4. Diodengleichrichterschaltung nach Anspruch 3, **dadurch gekennzeichnet, dass** die Eingangsgleichspannung (U_{IN}) zwischen dem doppelten und dreifachen Wert der Schwellspannung (U_{T}) einer Diode (D1, D2) liegt.

5. Diodengleichrichterschaltung nach Anspruch 1, **dadurch gekennzeichnet, dass** die temperaturkompensierte Diodengleichrichterschaltung mit doppeltem Diodengleichrichter (D11, D21, C11, C21,R11, R21) aber einer gemeinsamen Kompensationsdiode (D2) in einem mobilen Telefon, das für einen Betrieb in verschiedenen Frequenzbändern ausgelegt ist, benutzt wird, wobei der Diodengleichrichter (D11, D21, C11, C21, R11, R21) auf der einen Seite mit der Eingangsgleichspannung und auf der anderen Seite mit dem Gleichrichtereingang verbunden ist, und wobei die gemeinsame Kompensationsdiode (D2) mit dem doppelten Diodengleichrichter über einen Widerstand (R2) verbunden ist.

## Claims

1. Temperature-compensated diode rectifier circuit which
- is coupled on the output side to an HF amplifier (PA) for the purpose of deriving a rectified voltage (U_{D}) from an HF output signal (RF_{OUT}) with a rectifier input (I_{R}) via a directional coupler (D-CO) with secondary terminals (1, 2),
- exhibits a rectifier output (OR) for the rectified voltage (U_{D}), a rectifier diode (D1), a charging capacitor (C1) and a ballast resistor (R2),
- is connected to a stabilised d.c. input voltage (U_{IN}) via the rectifier input (I_{R}) for the purpose of stabilising the rectified voltage against temperature influences within a temperature range that is permitted for use, and also contains a balancing diode (D2) in series with the ballast resistor (R2), and a dropping resistor (R1) in series with the rectifier diode (D1),
**characterised**
- **in that** the terminals of the directional coupler (D-CO) are connected, on the one hand, to the d.c. input voltage and, on the other hand, to the rectifier input, with the rectifier diode (D1), the balancing diode (D2), the dropping resistor (R1), the ballast resistor (R2) and the directional coupler (D-CO) being connected to the d.c. input voltage (U_{IN}) in such a way that the voltage amplitude of the decoupled HF output signal (RF_{OUT}) is added to the d.c. input voltage (U_{IN}),
- **in that** the dropping resistor (R1) of the rectifier diode (D1) is situated between the charging capacitor (C1) and the rectifier output (OR), and
- **in that** the d.c. input voltage (U_{IN}) is only slightly higher than twice the threshold voltage (U_{T}) of a diode (D1 , D2).

2. Diode rectifier circuit according to Claim 1, **characterised in that** one secondary terminal (1) of the directional coupler (D-CO) is directly connected to the d.c. input voltage (U_{IN}), and the other terminal (2) is directly connected to the rectifier input (IN_{R}), so that the HF a.c. voltage that is inductively decoupled by the directional coupler (D-CO) is in series with the d.c. input voltage (U_{IN}).

3. Diode rectifier circuit according to Claim 1, **characterised in that** the d.c. input voltage (U_{IN}) lies a few hundredths of a volt above twice the threshold voltage (U_{T}) which the diodes (D1, D2) exhibit at the minimum operating temperature within the permitted temperature range.

4. Diode rectifier circuit according to Claim 3, **characterised in that** the d.c. input voltage (U_{IN}) is between two and three times the value of the threshold voltage (U_{T}) of a diode (D1, D2).

5. Diode rectifier circuit according to Claim 1, **characterised in that** the temperature-compensated diode rectifier circuit with the double diode rectifier (D11, D21, C11, C21, R11, R21) but with a common balancing diode (D2) is used in a mobile telephone that is designed for operation in various frequency bands, the diode rectifier (D11, D21, C11, C21, R11, R21) being connected, on the one hand, to the d.c. input voltage and, on the other hand, to the rectifier input, and the common balancing diode (D2) being connected to the double diode rectifier via a resistor (R2).

## Revendications

1. Circuit redresseur à diodes compensé en température, dont une entrée de redressement (I_{R}) est couplée au moyen d'un coupleur directionnel (D-CO) présentant des branchements secondaires (1, 2), à la sortie d'un amplificateur (HFPA) pour délivrer une tension redressée (U_{D}) à partir d'un signal de sortie HF (RF_{OUT}).
- ledit circuit redresseur présentant une sortie de redresseur (OR) pour la tension redressée (U_{D}), une diode de redressement (D1), un condensateur de lissage (CI) et une résistance de charge (R2),
- ledit circuit redresseur étant relié par l'entrée de redresseur (I_{R}) à une tension continue d'entrée (U_{IN}) stabilisée pour la stabilisation de la tension redressée vis-à-vis des influences de température dans les limites d'une plage de températures autorisée pour l'utilisation et comprenant une diode de compensation (D2) en série avec la résistance de charge (R2) et une résistance amont (R1) en série avec la diode de redressement (D1),
**caractérisé en ce que**
- les branchements du coupleur directionnel (D-CO) sont reliés d'un côté à la tension continue d'entrée et de l'autre côté à l'entrée de redresseur, la diode de redressement (D1), la diode de compensation (D2), la résistance amont (R1), la résistance de charge (R2) et le coupleur directionnel (D-CO) étant reliés à la tension continue d'entrée (U_{IN}) de telle sorte que l'amplitude de tension du signal de sortie HF (RF_{OUT}) découplée s'ajoute à la tension continue d'entrée (U_{IN}),
- **en ce que** la résistance amont (R1) de la diode de redressement (D1) se situe entre le condensateur de lissage (C1) et la sortie de redressement (OR) et
- **en ce que** la tension continue d'entrée (U_{IN}) n'est que légèrement supérieure au double de la tension seuil (U_{T}) d'une diode (D1, D2),

2. Circuit redresseur à diodes selon la revendication 1, **caractérisé en ce qu'**un branchement (1) secondaire du coupleur directionnel (D-CO) est relié directement à la tension continue d'entrée (U_{IN}) et l'autre branchement (2) directement à l'entrée de redresseur (IN_{R}), de sorte que la tension alternative HF dissociée par induction du coupleur directionnel (D-CO) est disposée en série avec la tension continue d'entrée (U_{IN}).

3. Circuit redresseur à diodes selon la revendication 1, **caractérisé en ce que** la tension continue d'entrée (U_{IN}) se situe quelques centièmes de volt au-dessus du double de la tension seuil (U_{T}), que les diodes (D1, D2) présentent à la température de service minimale dans la plage de températures autorisée.

4. Circuit redresseur à diodes selon la revendication 3, **caractérisé en ce que** la tension continue d'entrée (U_{IN}) se situe entre le double et le triple de la tension seuil (U_{T}) d'une diode (D1, D2).

5. Circuit redresseur à diodes selon la revendication 1, **caractérisé en ce que** le circuit redresseur à diodes compensé en température avec double redresseur à diodes (D11, D21, C11, C21, R11, R21), mais avec une diode de compensation (D2) commune est utilisé dans un téléphone mobile qui est conçu pour un fonctionnement dans différentes bandes de fréquence, le redresseur à diodes (D11, D21, C11, C21, R11, R21) étant relié d'un côté à la tension continue d'entrée et de l'autre côté à l'entrée du redresseur, et la diode de compensation (D2) commune étant reliée au double redresseur à diodes par une résistance (R2).
